(19) **Europäisches Patentamt / European Patent Office / Office européen des brevets**

(11) **EP 1 506 581 B1**

(12) **FASCICULE DE BREVET EUROPEEN**

(45) Date de publication et mention
de la délivrance du brevet:
**11.02.2009 Bulletin 2009/07**

(21) Numéro de dépôt: **03747489.7**

(22) Date de dépôt: **05.05.2003**

(51) Int Cl.:
*H01L 39/22* (2006.01)     *G06N 1/00* (2006.01)

(86) Numéro de dépôt international:
**PCT/FR2003/001386**

(87) Numéro de publication internationale:
**WO 2003/094250 (13.11.2003 Gazette 2003/46)**

(54) **DISPOSITIF DE BIT QUANTIQUE SUPRACONDUCTEUR A JONCTIONS JOSEPHSON**

SUPRALEITENDE QUANTEN-BIT-EINRICHTUNG MIT JOSEPHSON-ÜBERGÄNGEN

SUPERCONDUCTING QUANTUM BIT DEVICE WITH JOSEPHSON JUNCTIONS

(84) Etats contractants désignés:
**AT BE BG CH CY CZ DE DK EE ES FI FR GB GR HU IE IT LI LU MC NL PT RO SE SI SK TR**

(30) Priorité: **03.05.2002 FR 0205599**

(43) Date de publication de la demande:
**16.02.2005 Bulletin 2005/07**

(73) Titulaire: **COMMISSARIAT A L'ENERGIE ATOMIQUE**
**75015 Paris (FR)**

(72) Inventeurs:
• **ESTEVE, Daniel**
**F-78220 Viroflay (FR)**
• **VION, Denis**
**F-91190 Gif sur Yvette (FR)**
• **DEVORET, Michel**
**F-75013 Paris (FR)**
• **URBINA, Cristian**
**F-91190 Gif sur Yvette (FR)**
• **JOYEZ, Philippe**
**F-91400 Orsay (FR)**
• **POTHIER, Hugues**
**F-75014 Paris (FR)**

• **ORFILA, Pierre-François**
**F-91120 Palaiseau (FR)**
• **AASSIME, Abdelhahim**
**F-91300 Massy (FR)**
• **COTTET, Audrey**
**F-91120 Palaiseau (FR)**

(74) Mandataire: **Thévenet, Jean-Bruno**
**Cabinet Beau de Loménie**
**158, rue de l'Université**
**75007 Paris (FR)**

(56) Documents cités:
• **COTTET A ET AL: "Implementation of a combined charge-phase quantum bit in a superconducting circuit" PHYSICA C, vol. 367, no. 1-4, 15 février 2002 (2002-02-15), pages 197-203, XP004332029 ISSN: 0921-4534**
• **ZORIN A B: "Cooper-pair qubit and Cooper-pair electrometer in one device" PHYSICA C, vol. 368, no. 1-4, 1 mars 2002 (2002-03-01), pages 284-288, XP004336224 ISSN: 0921-4534**
• **VION D ET AL: "Manipulating the quantum state of an electrical circuit" SCIENCE, vol. 296, no. 5569, 3 mai 2002 (2002-05-03), pages 886-889, XP002267491 ISSN: 0036-8075**

EP 1 506 581 B1

**Description**

Domaine Technique

La présente invention a pour objet un dispositif de bit quantique supraconducteur à jonctions Josephson. La présente invention appartient au domaine du calcul quantique, et constitue une réalisation du composant élémentaire dénommé "bit quantique", également appelé qubit. Ce composant est un dispositif physique n'ayant que deux états quantiques (par exemple au repos et excité) que l'on notera conventionnellement par les vecteurs d'état kets |0> et |1>, ce composant pouvant être placé dans une superposition cohérente de ces états, cette superposition étant notée :

a|0> + b|1>

où les coefficients a et b peuvent prendre des valeurs arbitraires respectant la normalisation de l'état.

Pour qu'un qubit soit utilisable pour le calcul quantique, il faut :

a/ que son état quantique puisse être manipulé par une commande externe de façon arbitraire (réalisation du groupe des opérations unitaires de SU(2), où SU(2) représente l'espace des états du qubit). Ainsi, il faut notamment pouvoir préparer une superposition cohérente quelconque a | 0> + b | 1 > des deux états quantiques du qubit (phase d'écriture),

b/ pouvoir lire cet état quantique fidèlement (phase de lecture),

c/ un temps de cohérence du qubit suffisamment long pour permettre la manipulation de cet état et le couplage avec un ou plusieurs autres qubits pour réaliser des portes logiques (phase de calcul).

Des qubits satisfaisant aux conditions a, b et c ci-dessus sont destinés à être, dans une phase ultérieure, couplés entre eux et associés de manière à réaliser physiquement des opérations logiques pour être utilisés dans des processeurs quantiques.

Les qubits actuels sont de deux types :

1/ ceux du premier type sont fondés sur des objets naturellement quantiques comme des atomes, des ions ou des spins nucléaires. Leur temps de cohérence est a priori long (jusqu'à plusieurs secondes) ; en revanche l'interconnexion à d'autres bits quantiques est délicate à mettre en oeuvre et l'intégration dans un même dispositif d'un nombre suffisant de qubits pour réaliser des calculs ne semble guère réaliste dans l'état actuel des connaissances.
2/ ceux du deuxième type sont fondés sur des objets fabriqués, généralement à l'aide de micro ou de nano-technologies, comme les circuits électriques supraconducteurs. Leur temps de cohérence est a priori plus bref, mais en revanche l'interconnexion avec d'autres bits quantiques se présente plus favorablement. L'intégration d'un grand nombre de qubits sur un même substrat devrait en effet bénéficier de l'expérience de la micro-fabrication acquise sur les composants électroniques.

L'invention appartient à ce second type, et concerne un qubit nano fabriqué, essentiellement constitué d'un circuit électrique fait d'un matériau supraconducteur de type S à base de jonctions Josephson. De tels qubits sont destinés à être couplés électromagnétiquement entre eux et intégrés sur un circuit micro-fabriqué de manière à réaliser physiquement des opérations logiques, puis plus tard encore des processeurs électroniques quantiques.

On rappelle qu'une jonction Josephson est caractérisée par deux grandeurs fixées à sa fabrication, notamment par ses dimensions : l'une est l'énergie Josephson $E_J$ qui correspond au couplage entre les électrodes supraconductrices, et l'autre est l'énergie de Coulomb $E_c = 2e^2/C_J$ qui correspond à l'énergie électrostatique nécessaire pour stocker une paire de Cooper sur la capacité $C_J$ de la jonction. Pour un système à plusieurs jonctions Josephson, on peut définir une énergie Josephson et une énergie de Coulomb effectives pour chaque branche ou îlot du circuit.

Une jonction est un système physique à un seul degré de liberté : la différence de phase supraconductrice à ses bornes, variable conjuguée du nombre de paires de Cooper l'ayant traversée. Une jonction peut être dans un régime de phase ou de charge, selon la valeur du rapport effectif $E_J / E_C$ du circuit auquel appartient cette jonction. Un circuit multi-jonctions a donc plusieurs degrés de liberté, mais on distingue les degrés dits principaux, qui sont actifs, des autres qui sont inopérants.

Etat de l'art

Les circuits qubits supraconducteurs à jonctions Josephson existants présentent un degré de liberté principal qui est soit une charge électrique (nombre de paires de Cooper dans une partie de circuit), soit une différence de phases supraconductrices δ aux bornes d'une ou plusieurs jonctions Josephson (ou le courant qui en résulte).

De façon simplifiée, la nature charge ou phase du degré de liberté principal est déterminée essentiellement par le rapport entre l'énergie Josephson $E_J$ des jonctions du qubit et leur énergie de Coulomb $E_C$. Lorsque ce rapport est inférieur à l'unité, le degré de liberté principal est une charge, lorsqu'il est supérieur à une dizaine, le degré de liberté principal est une phase. En régime intermédiaire, les deux caractères charge et phase apparaissent selon le circuit.

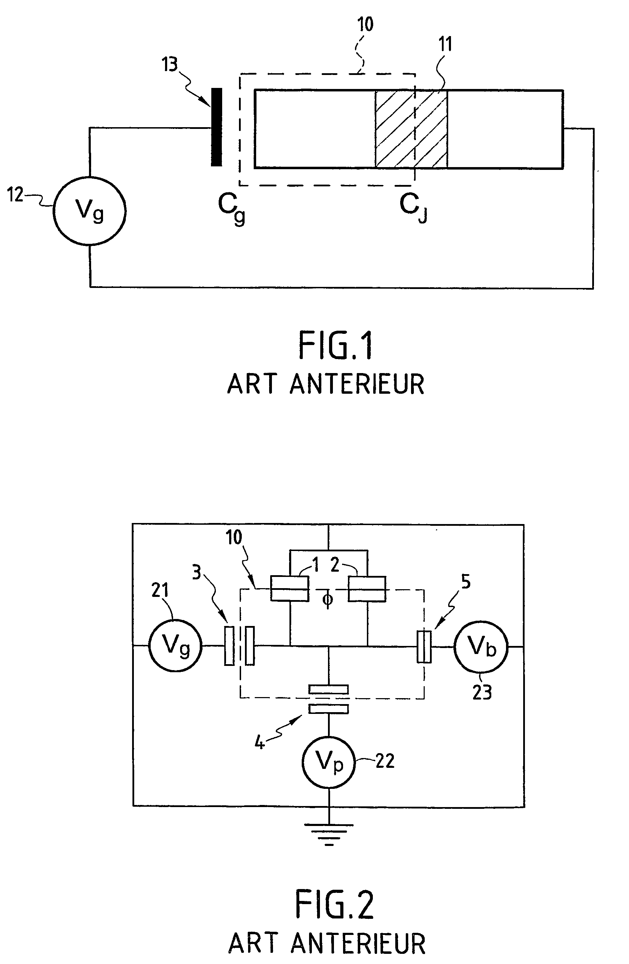

Parmi les circuits fondant leur comportement quantique sur une charge, le plus connu est « la boîte à paires de Cooper » décrite pour la première fois par le document "Quantum coherence with a single Cooper pair", V. Bouchiat, D. Vion, P. Joyez, D. Esteve, and M. H. Devoret, Physica Scripta, T76, 165 (1998). Elle est désormais bien connue de l'homme du métier, et on se bornera à rappeler qu'une boîte à paires de Cooper comprend une portion de circuit supraconducteur isolée du reste du circuit par un ou des matériaux isolants (ou le vide), et couplée au reste du circuit par au moins une jonction Josephson. La Figure 1 représente schématiquement une telle portion de circuit 10, appelée îlot, comprise entre l'isolant 11 de la jonction Josephson et l'isolant d'un condensateur 13 connecté en série de capacité $C_g$ et dont l'autre extrémité est reliée à une source de tension de polarisation 12 de valeur $V_g$. Ce condensateur 13 réalise un couplage capacitif entre l'îlot et la source de tension continue réglable de polarisation 12, qui détermine le point de fonctionnement du circuit. La superposition d'états quantiques de l'îlot est obtenue par une séquence adéquate d'impulsions radiofréquences ou continues appliquées soit au même condensateur 13, soit à une autre électrode également couplée capacitivement à l'îlot. Le problème majeur d'un tel dispositif réside dans l'existence de charges électriques, fluctuant de manière erratique, au voisinage immédiat de l'îlot. Ce « bruit » en charge d'une part réduit le temps de cohérence de l'état quantique de la boîte à paires de Cooper 10, et d'autre part brouille toute mesure de la charge de cet état par un électromètre.

L'électromètre peut être remplacé par un autre circuit de mesure, comme indiqué dans le document "Coherent control of macroscopic quantum states in a single-Cooper-pair box" de Nakamura et al. de la société NEC, NATURE, vol. 398 du 29/04/1999. La représentation schématique de ce circuit est reproduite en figure 2 de la présente demande. L'îlot 10 de la boîte à paires de Cooper est délimité par deux jonctions Josephson 1 et 2, un condensateur 3 relié à la source 21 de tension continue réglable de polarisation $V_g$ ainsi que par un condensateur 4 relié à une source d'impulsions radiofréquences de tension $V_p$ à la fréquence de transition de l'îlot. L'îlot est aussi délimité par une troisième jonction Josephson 5, de dimensions très faibles, et ne constituant qu'un couplage à une source de tension 23 délivrant une tension $V_b$ et un ampèremètre (non représenté) destinés à lire l'état du qubit. Bien que cette jonction Josephson de lecture 5 ait une résistance quelques centaines de fois plus élevée que la résistance des autres jonctions Josephson, l'observation permanente qu'elle effectue sur le qubit conduit à sa perte rapide de cohérence. Cette méthode de lecture qui est moins sensible au bruit en charge aggrave la décohérence du qubit au point d'hypothéquer son fonctionnement. Le temps de cohérence obtenu, limité par le bruit en charge et la lecture permanente, est de quelques nanosecondes.

On peut remarquer que dans les deux méthodes de lecture ci-dessus, le même degré de liberté, la charge électrique, est utilisé pour l'écriture et pour la lecture du qubit.

Plus synthétiquement, on peut dire que la boîte à paires de Cooper, comme tout circuit qui fonde son comportement quantique sur un seul degré de liberté en charge, est soit affectée d'un bruit de charge excessif, soit affectée d'une trop grande brièveté du temps de cohérence.

Ce bruit de charges étant lié à un environnement électrostatique extrêmement difficile à maîtriser, les chercheurs de l'Université de Technologie de DELFT aux Pays-Bas se sont efforcés de réaliser un qubit dont les degrés de liberté sont des phases. Le degré de liberté principal donne naissance à des courants permanents au sein d'une boucle supraconductrice. Ces travaux sont rapportés dans les deux documents mentionnés ci-dessous.

Le premier document de l'UT-DELFT "Josephson persistent-current qubit" de J.E.Mooij, C.van der Wal, et al, pp 1037-1039, SCIENCE, vol. 285 du 13/08/1999 est avant tout un projet de réalisation. On y décrit un qubit proprement dit constitué de trois jonctions Josephson connectées en série dans une boucle supraconductrice, traversée par un flux magnétique ajustable. Deux de ces jonctions Josephson ont la même énergie Josephson $E_J$, et la troisième a une énergie Josephson plus faible, préférentiellement de 0,75 $E_J$.

Ces trois jonctions Josephson sont en outre construites de telle manière que le rapport entre leur énergie Josephson $E_J$ et leur énergie de Coulomb $E_C$ soit de l'ordre de 80.

Les deux états quantiques fondamentaux donnent naissance dans la boucle supraconductrice à des courants de sens opposés $i_0$ et $i_1$. Selon un premier mode de réalisation décrit dans ce document, l'écriture s'effectue par des impulsions radiofréquence de courant envoyées dans un conducteur de commande situé au voisinage de la boucle supraconductrice. Il est schématisé par un fil rectiligne magnétiquement couplé à la boucle, et réalisé sur un niveau différent par rapport au substrat.

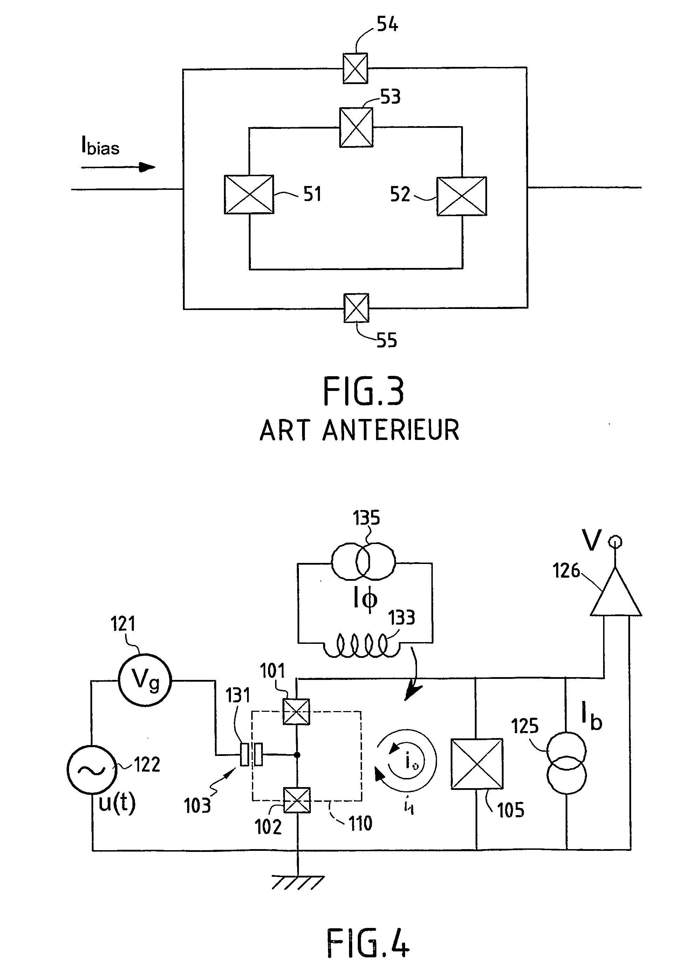

Le second document de l'UT-DELFT "Quantum superposition of macroscopic persistent-current states" de C.Van der Wal, J.E. Mooij et al, pp 773-776, SCIENCE, vol 290 du 27/10/2000, décrit une réalisation de l'un des qubits proposés dans le document précédent (boucle supraconductrice à trois jonctions Josephson). La figure 1A de ce document montre schématiquement un bit quantique proprement dit, limité à trois jonctions supraconductrices Josephson. Elle est reproduite en Figure 3 de la présente demande, où les trois jonctions Josephson sont référencées 51, 52 et 53.

Le circuit d'écriture, non représenté sur le schéma, est un simple fil dans lequel une impulsion de courant est envoyée pour les opérations d'écriture comme dans la proposition du premier document précité de l'UT-DELFT. Le circuit de lecture recourt à un SQUID couplé magnétiquement au qubit, et constitué des jonctions Josephson 54 et 55.

Un tel qubit a un temps de cohérence de 15 ns, trop court pour être manipulable, et l'efficacité de la lecture est très faible (rapport signal sur bruit S/B<0,1, soit en anglais S/N<0.1). On peut remarquer par ailleurs que c'est la même grandeur physique qui est impliquée dans l'écriture et la lecture du qubit.

Le document WO 01 50534 ayant pour titre "Qubit using a Josephson junction between S-wave and D-wave superconductors" décrit une proposition théorique de qubit Josephson basé sur une boîte à paires de Cooper dont l'une des électrodes de la jonction Josephson est un supraconducteur non BCS avec une symétrie de fonction d'onde de type D, l'autre étant un supraconducteur conventionnel avec une symétrie de type S. Le choix de ces deux types de supraconducteurs de symétries différentes S et D est essentiel pour le fonctionnement de ce circuit car la méthode de lecture repose sur l'existence de moments magnétiques dans une telle jonction SD. Un tel dispositif ne peut en aucun cas fonctionner sans le supraconducteur de type D. Ces supraconducteurs étant des céramiques, les jonctions SD sont très délicates à mettre en oeuvre. La lecture est basée sur l'utilisation de transistors à un électron.

Le document WO 02 15290 "Shaped Josephson junction qubits" décrit une proposition théorique de qubit Josephson et les résultats préliminaires d'une réalisation. Le qubit décrit est basé sur les états de phase d'une jonction Josephson longue en forme d'anneau, dans laquelle la phase subit une rotation de $2\pi$ au cours d'un quantum de flux dans la boucle. Les deux niveaux quantiques du qubit n'ont pas été observés, et le temps de cohérence n'a donc pas pu être déterminé.

Ainsi, les qubits supraconducteurs à jonctions Josephson existants, que leurs degrés de liberté principaux soient seulement des charges, ou seulement des phases $\delta$, ne parviennent pas à atteindre un temps de cohérence suffisamment long pour permettre une lecture fiable de leur état. Ils ont par ailleurs une caractéristique en commun : ils recourent à une même grandeur physique à la fois pour modifier l'état du qubit (écriture) et pour le mesurer (lecture).

L'article de A. Cottet et al intitulé "Implementation of a combined charge-phase quantum bit in a superconducting circuit" paru dans la revue Physica C, Vol. 367, N° 1-4 du 15 février 2002, pages 197-203 décrit un dispositif de bit quantique supraconducteur à jonctions Josephson présentant un premier degré de liberté principal affecté à l'écriture constitué par une charge et un deuxième degré de liberté principal affecté à la lecture constitué par une phase, le dispositif comprenant une boîte à paire de Cooper et une boucle supraconductrice pour former un qubit, un circuit d'écriture, un circuit de lecture et des moyens aptes à faire traverser la boucle supraconductrice par un flux magnétique ajustable agissant sur la phase du qubit.

Exposé de l'invention

Le qubit selon l'invention vise à éviter les inconvénients de l'art antérieur, notamment la brièveté du temps de cohérence et la faible fidélité de la lecture. Un autre but de l'invention est de faciliter le couplage de plusieurs qubits, de préférence sur un même substrat.

Ces buts sont atteints conformément à l'invention, grâce à un dispositif de bit quantique supraconducteur à jonctions Josephson présentant un premier degré de liberté principal affecté à l'écriture constitué par une charge et un deuxième degré de liberté principal affecté à la lecture constitué par une phase, ce dispositif comprenant :

- une boîte à paires de Cooper comportant des première et deuxième jonctions Josephson délimitant un îlot de charge de la boîte à paires de Cooper et se refermant sur une boucle supraconductrice pour former un qubit,
- un circuit d'écriture comprenant une électrode de grille placée en regard de ladite boîte à paires de Cooper et constituant avec elle un condensateur de capacité $C_9$, l'électrode de grille capacitivement liée à l'îlot de charges permettant de placer ce qubit dans l'un ou l'autre des deux états de base du qubit ou dans une superposition cohérente de ces états, une tension de polarisation $V_g$ étant appliquée à l'électrode de grille à partir d'une source de tension ajustable,
- un circuit de lecture comprenant une jonction Josephson de lecture $J_L$ insérée dans ladite boucle supraconductrice, et d'énergie Josephson sensiblement supérieure à l'énergie Josephson de chacune desdites première et deuxième jonctions Josephson, et
- des moyens aptes à faire traverser la boucle supraconductrice par un flux magnétique ajustable agissant sur la phase $\delta$ du qubit,

ce dispositif étant caractérisé en ce que les jonctions Josephson définissant l'îlot de charge présentent un rapport $E_J/E_C$ entre leur énergie Josephson $E_J$ et leur énergie de Coulomb $E_C$ qui est compris entre 1 et 3, en ce que la jonction Josephson de lecture $J_L$ a une énergie Josephson au moins 50 fois supérieure à l'énergie Josephson de chacune desdites première et deuxième jonctions Josephson, et en ce que la jonction Josephson de lecture a un rapport $E_J/E_C$ effectif, compte tenu de la capacité ajoutée par le circuit de lecture, assez grand pour que les fluctuations de sa phase induites par le circuit extérieur soient inférieures à 0,01 rad.

La boucle supraconductrice est construite de telle manière que la fréquence de transition $v_{01}$ du qubit ainsi formé puisse être ajustée à une valeur stationnaire vis-à-vis des paramètres et perturbations extérieures.

Selon un mode de réalisation préférentiel, le dispositif comprend un circuit de lecture, indépendant du circuit d'écriture, galvaniquement connecté à la dite boucle supraconductrice du qubit, et comportant, outre la jonction Josephson de lecture, d'une part des moyens pour appliquer pendant la phase de lecture une impulsion de courant $I_b$ de durée et d'amplitude paramétrables, et d'autre part des moyens de détection des sauts de phase de $2\pi$ aux bornes de la jonction Josephson de lecture qui apparaissent, suite à l'impulsion de lecture, pour l'un des deux états exclusivement.

Avantageusement, le dispositif est préréglé par ses paramètres Ng de charge de polarisation, et $\delta$ de différence de phases supraconductrices liée au flux magnétique $\Phi_J$ traversant la boucle supraconductrice et au courant de lecture $I_b$, en un point de fonctionnement $F_i$ où la fréquence de transition $v_{01}$ du qubit est stationnaire vis-à-vis des deux paramètres de réglage $N_g$ et $\delta$, ce point correspondant aussi à une stationnarité vis-à-vis des paramètres extérieurs.

Le point de fonctionnement $F_i$ du dispositif peut être le point $F_1$ constituant un point col du graphe tridimensionnel représentant la fréquence propre $v_{01}$ du qubit en fonction de $N_g$ et $\delta$.

Selon une autre variante de réalisation, le point de fonctionnement $F_i$ est un point $F_2$ ou $F_3$ constituant un point sommet du graphe tridimensionnel représentant la fréquence propre $v_{01}$ du qubit en fonction de $N_g$ et $\delta$.

Avantageusement, en dehors des séquences de lecture produisant des impulsions de lecture ayant une valeur de crête $I_{bc}$, les moyens d'application d'une impulsion de courant délivrent un courant de repos négatif par rapport au sens des impulsions de lecture, avec une valeur absolue inférieure à la valeur de crête $I_{bc}$, par exemple de l'ordre de -0,25 $I_{bc}$, permettant d'obtenir, lorsqu'une impulsion de lecture arrive, un déplacement de la différence de phase supraconductrice $\delta$ compris entre $\pi/2$ et $\pi$.

Brève description des dessins

D'autres caractéristiques et avantages de l'invention ressortiront de la description suivante de modes particuliers de réalisation, donnés à titre d'exemples, en référence aux dessins annexés, sur lesquels :

- les Figures 1 à 3 représentent schématiquement des exemples de circuits de l'art antérieur,
- la Figure 4 est un schéma-bloc illustrant de façon synthétique un dispositif de bit quantique supraconducteur selon l'invention,
- la Figure 5 est un diagramme en trois dimensions illustrant le choix du point de fonctionnement d'un dispositif de bit quantique selon l'invention,
- la Figure 6 est un diagramme illustrant le déplacement adiabatique de l'état du système d'un dispositif de bit quantique selon l'invention, durant une impulsion de mesure,
- la Figure 7 est un schéma illustrant un mode particulier de réalisation d'un dispositif de bit quantique supraconducteur selon l'invention,
- la Figure 8 représente des exemples de chronogrammes de signaux intervenant dans les manipulations ou la mesure d'état quantiques d'un dispositif de bit quantique selon l'invention,
- la Figure 9 est un diagramme représentant les interférences de Ramsey du dispositif de bit quantique selon l'invention, qui montrent son temps de cohérence, et
- la Figure 10 est un schéma illustrant un exemple de couplage de deux exemples de dispositifs de bit quantique supraconducteurs selon l'invention.

Exposé détaillé de modes de réalisation particuliers de l'invention

Un dispositif de bit quantique supraconducteur (ou qubit) selon l'invention permet d'accroître le temps de cohérence par rapport aux dispositifs de l'art antérieur et d'augmenter la fidélité de lecture. Pour cela, il utilise simultanément deux degrés de liberté principaux : une charge et une phase $\delta$.

Le dispositif selon l'invention sera décrit plus particulièrement à l'aide du schéma de la Figure 4.

Le degré de liberté principal est celui d'une boîte à paires de Cooper 110 dont le rapport entre l'énergie Josephson $E_J$ et l'énergie de Coulomb $E_C$ de la jonction effective correspondant à la mise en parallèle des deux jonctions 101, 102 est compris entre 1 et 12, et préférentiellement entre 5 et 12. Sa nature en charge est exploitée pour la manipulation du bit quantique en appliquant des tensions sur l'électrode de grille 131 de la boîte 110. Le degré de liberté principal de la nature d'une phase $\delta$ est caractérisé par le rapport entre l'énergie Josephson $E_{JL}$ et l'énergie de Coulomb $E_{JC}$ d'une troisième jonction Josephson 105, incluse dans une boucle supraconductrice de type S se refermant sur la boîte à paires de Cooper 110, et constituant l'élément détecteur du circuit de lecture : ce rapport est supérieur à 5000. L'écriture s'effectue d'une part en agissant sur le degré de liberté de charge en appliquant à l'électrode de grille 131 de la boîte 110 (couplage par le condensateur 103 de capacité Cg) une tension continue $V_g$ à partir d'une source de tension 121 pour atteindre le point de fonctionnement optimal $N_g$=1/2, où $N_g$ représente la charge de polarisation réduite de l'îlot ($C_g V_g/2e$) et d'autre part, à partir d'une source 122, des impulsions radiofréquence u(t) à la résonance ou au voisinage de la résonance avec le qubit de la boîte 110. Lors de la lecture, une impulsion de courant $I_b$ est appliquée à la jonction de lecture 105, à partir d'une source de courant 125, pour l'amener près de son courant critique. La détermination de l'état du bit quantique s'effectue en détectant ou non un ou des sauts de phase de $2\pi$ pour la jonction de lecture 105. Lorsque ces sauts de phase forment une avalanche ininterrompue, la lecture s'effectue en mesurant la tension V aux bornes de la jonction de lecture 105 à l'aide d'un circuit amplificateur 126. Les deux états du qubit correspondent fidèlement à l'apparition ou non d'une tension finie. Lorsque le qubit est en écriture ou encore en maintien / calcul, cette jonction de lecture 105 se comporte comme un court-circuit en raison de son énergie Josephson $E_{JL}$ de l'ordre de 50 à 100 fois supérieure à l'énergie Josephson de chacune des deux autres jonctions 101, 102.

On peut également définir le qubit selon l'invention en ce qu'il se fonde sur un dispositif à deux degrés de liberté quantiques auxquels sont associées deux grandeurs physiques de nature différente :

- une variation de tension (ou de charge) sur une électrode de grille qui permet l'écriture d'une superposition cohérente a | 0> + b |1> des deux états quantiques du qubit,
- une différence de phase ou un courant dans une boucle en matériau supraconducteur de type S comme par exemple les supraconducteurs à base d'aluminium ou de niobium, dont la mesure permet de lire l'état du qubit

Ce dispositif est apte à être placé dans les conditions qui maximisent le temps de cohérence. Cette indépendance des deux ports est un avantage essentiel pour découpler l'écriture de la lecture.

On peut encore définir ce circuit supraconducteur qubit selon l'invention en ce que :

a) il comporte un îlot supraconducteur entre deux jonctions Josephson 101, 102 d'énergie Josephson $E_{J1}$ et $E_{J2}$ comparables, ces jonctions étant comprises dans une boucle supraconductrice de type S, la boucle étant construite de telle manière que la fréquence de transition du qubit puisse être ajustée électriquement à une valeur stationnaire des paramètres et perturbations extérieures,

b) il comporte une électrode 131 capacitivement liée à l'îlot supraconducteur, que la configuration du circuit rend apte à régler la fréquence de transition entre les deux états du qubit, cette électrode étant par ailleurs apte, lors des phases d'écriture, à placer le qubit dans une superposition cohérente des deux états du qubit,

c) il comporte des moyens 133, 135 d'appliquer à la boucle supraconductrice un flux magnétique $\phi$, que la configuration du circuit rend apte à régler la fréquence de transition $v_{01}$ entre les deux états du qubit,

d) il comporte une troisième jonction Josephson 105 dite jonction Josephson de lecture $J_L$, dont l'énergie Josephson $E_{JL}$ vaut de l'ordre de 50 fois à 100 fois, et préférentiellement environ 80 fois, l'énergie Josephson $E_{J1}$ ou $E_{J2}$, des jonctions Josephson 101, 102 définies ci-dessus, cette jonction Josephson de lecture 105 fonctionnant alors comme un court-circuit supraconducteur lors des phases d'écriture ou de maintien, et fonctionnant comme un détecteur à seuil lors de la phase de lecture,

e) il comporte un circuit de lecture, indépendant du circuit d'écriture, galvaniquement connecté à la boucle supraconductrice du qubit, et comportant, outre la jonction Josephson de lecture 105, d'une part des moyens 125 pour appliquer pendant l'étape de lecture une impulsion de courant $I_b$ de durée et d'amplitude ajustables, et d'autre part des moyens 126 de détection des sauts de phase aux bornes de la jonction Josephson de lecture 105 sous l'effet conjugué de l'état du qubit et de l'impulsion de lecture.

Par ailleurs, l'ensemble du circuit électrique est conçu de telle manière que sa structure et son fonctionnement soient les plus symétriques possibles. De plus, le qubit est apte à être placé dans des conditions de fonctionnement qui favorisent le maintien de sa cohérence.

Ces conditions de fonctionnement qui favorisent le maintien de la cohérence du qubit objet de l'invention sont :

1) préalablement à son utilisation et durant la manipulation de l'état quantique, l'ajustement électrique de la fréquence de transition des deux états quantiques à une valeur stationnaire vis-à-vis de la tension continue $V_g$ appliquée au condensateur 103 de capacité $C_g$ sur l'électrode 131 n'appartenant pas à l'îlot de charges, et vis-à-vis du flux magnétique traversant le qubit,

2) lors des phases d'écriture (manipulation de l'état quantique), l'annulation de l'ensemble des courants circulant dans la boucle du qubit proprement dit, ceci par une combinaison particulière d'un flux magnétique et d'un courant dans la jonction de lecture 105,

3) le circuit de lecture n'est pas activé en permanence mais seulement à certains instants déterminés par des impulsions de lecture $I_b$.

L'îlot de charge peut, à travers le condensateur 103 de capacité $C_g$ qui lui est connecté, être polarisé en charge.

Ceci s'effectue en appliquant à l'électrode 131 du condensateur 103 n'appartenant pas à l'îlot, une superposition :

- d'une tension continue de polarisation $V_g$ qui en pratique détermine la fréquence de résonance de la boucle que constitue le qubit.
- d'une séquence d'oscillations de tension u(t) à cette fréquence de résonance ou au voisinage de celle-ci, leur amplitude et leur nombre permettant de placer le qubit dans une superposition cohérente a | 0> + b | 1 > de ses deux états quantiques.

Les jonctions Josephson 101, 102 délimitant l'îlot de charges sont choisies de manière telle que leur énergie Josephson $E_J$ soit proche de leur énergie de Coulomb $E_C$. Chacune d'elles a une électrode qui fait partie de l'îlot supraconducteur, et une électrode qui n'en fait pas partie. Entre les électrodes de chacune de ces jonctions qui n'appartiennent pas à l'îlot, la différence de phase δ imposée par l'impulsion de courant de lecture fait circuler dans la boucle du qubit des courants qui dépendent de son état.

Ces deux jonctions Josephson 101, 102 sont choisies de telle manière que leur énergie $E_J$ soit proche de leur énergie $E_C$, ce qui est généralement réalisé pour des jonctions de très petites dimensions. En outre, les énergies Josephson $E_J$ des jonctions 101, 102 présentent des valeurs les plus proches possibles. Les électrodes des jonctions Josephson n'appartenant pas à l'îlot se rejoignent pour former une boucle supraconductrice, l'ensemble formant le qubit proprement dit. En réalité, cette boucle comporte aussi la troisième jonction Josephson 105, mais de dimensions beaucoup plus grandes de sorte que pour cette dernière, l'énergie Josephson $E_J$ est très grande devant l'énergie de Coulomb $E_C$.

C'est cette caractéristique qui permet à la jonction de lecture de se comporter, en dehors des périodes de lecture, comme un court circuit supraconducteur.

Réglage du point de fonctionnement du qubit :

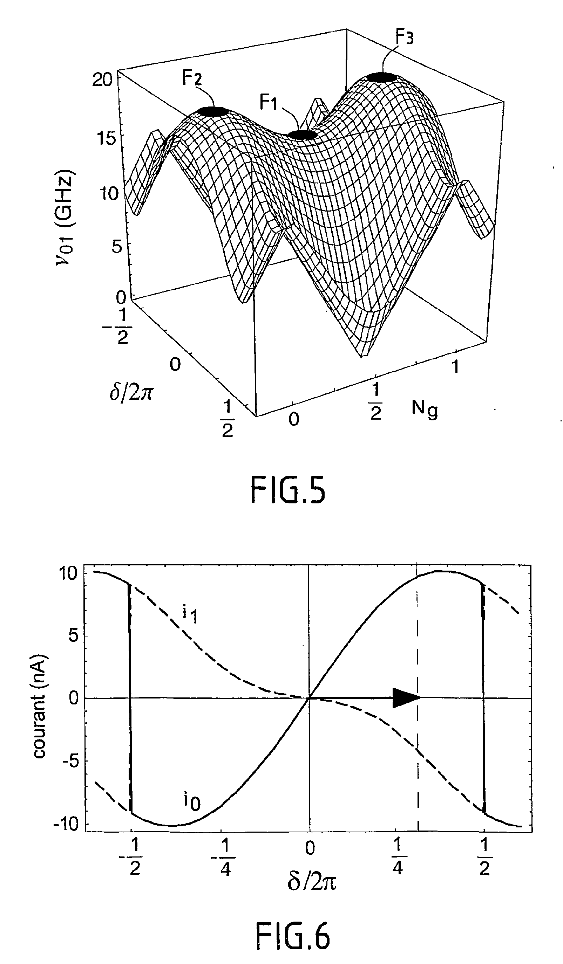

La fréquence de transition du qubit dépend des paramètres extérieurs que sont la charge couplée à l'îlot et le flux magnétique à travers la boucle. Un bruit en charge électrique ou en flux magnétique est donc susceptible de faire varier cette fréquence de transition durant la manipulation du qubit, et donc d'induire un déphasage aléatoire responsable de la décohérence de son état quantique. La sensibilité à ces bruits est donc minimale aux points de fonctionnement $F_1$, $F_2$, $F_3$ où la fréquence de transition $v_{01}$ est stationnaire vis-à-vis des paramètres extérieurs. Ces points de fonctionnement sont donc préférentiels. Pour un qubit selon l'invention les points possibles sont le point selle noté $F_1$ sur la Figure 5 ($N_g$=0,5 modulo 1 et δ =0 modulo 2π) ainsi que le point sommet $F_2$ ou $F_3$ à 2π près ($N_g$=0 ou 1 et δ =0) du graphe tridimensionnel.

Inscription d'un état ou d'une superposition cohérente d'états

L'amplitude de la tension alternative u(t) correspond à une charge couplée de l'ordre de 0,01 fois 2e.

Lecture de l'état du qubit :

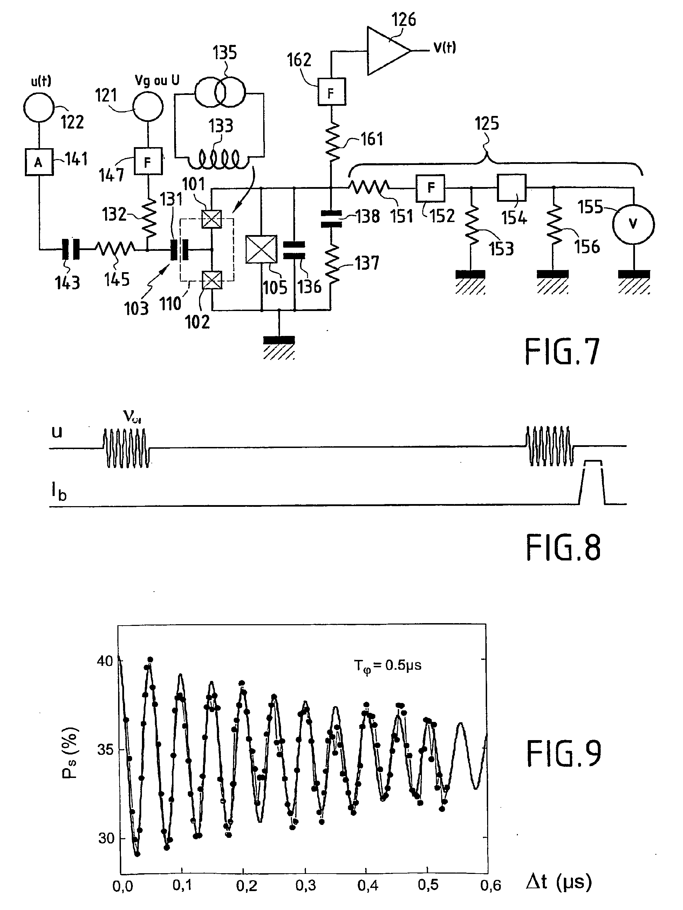

Pour la lecture de l'état du qubit, un générateur de courant 125 en parallèle avec la jonction Josephson de lecture 105 génère une impulsion $I_b$ (Figure 8) d'intensité et de durée ajustables (typiquement 100 ns). Lors d'une impulsion, ce générateur de courant 125 induit aux bornes de la jonction Josephson de lecture 105 une différence de phase supraconductrice γ qui, avec la différence de phases supraconductrices δ aux bornes de la boîte à paires de Cooper 100 et avec le flux magnétique φ traversant la boucle, vérifie l'équation suivante :

$$\delta = \gamma + (\phi/\phi_0)\ 2\pi \text{ en valeur absolue et modulo } 2\pi$$

où $\phi_0$ est le quantum de flux magnétique.

Au point de fonctionnement $F_1$ ($N_g$ = 0,5 modulo 1, δ=0 modulo 2π) pendant le temps de l'impulsion de lecture, la phase γ subit un déplacement qui engendre un déplacement de la phase δ. La jonction de lecture 105 commute autour de γ=π/2.

Durant la lecture, le courant doit être proche du courant critique de la jonction de lecture 105 de façon à avoir des taux de transition respectivement proches de 0% et de 100% pour les deux états du qubit. Le courant de polarisation $I_b$ en dehors de la lecture est choisi pour maintenir le circuit au point F choisi tels que les points $F_1$, $F_2$, $F_3$ de la Figure 5. Enfin, le choix du flux φ couplé à la boucle supraconductrice peut être optimisé pour que les courants de boucle $i_0$ et $i_1$ associés aux états l0> et l1>, révélés par l'impulsion de lecture, soient les plus différents possibles.

Optimisation de la lecture de l'état du qubit

Une optimisation de la lecture de l'état du qubit selon l'invention est réalisée en choisissant le flux magnétique φ induit au travers de la boucle supraconductrice pour que les courants de boucle $i_0$ et $i_1$ associés aux états | 0> et |1>, révélés par l'impulsion de lecture, soient les plus différents possibles. Pour compenser ce flux magnétique et maintenir une phase δ nulle correspondant au point de fonctionnement $F_i$, le générateur de courant de lecture délivre en dehors des séquences de lecture, non pas un courant de repos nul, mais un courant de repos de l'ordre de -0,25 $I_{bc}$, négatif par rapport au sens des impulsions de lecture. La valeur de crête $I_{bc}$ de ces impulsions reste inchangée. Selon cette optimisation préférentielle, le déplacement en phase δ au cours de l'impulsion de lecture sera compris entre π/2 et π.

Découplage du qubit de la jonction de lecture :

La boucle de lecture a des modes propres dont la fréquence doit être la plus éloignée possible de la fréquence propre du qubit proprement dit afin d'éviter la relaxation du qubit vers son état fondamental 10>.

Cette séparation entre les fréquences propres du qubit et de la jonction de lecture existe déjà du fait de la différence importante entre les dimensions et les caractéristiques de la jonction Josephson de lecture 105, et celles des jonctions Josephson 101, 102 délimitant l'îlot. Elle est volontairement augmentée par l'ajout d'un ou plusieurs condensateurs 136 (Figure 7) aux bornes de la jonction Josephson de lecture 105.

Maintien de la cohérence :

Le maintien de la cohérence du qubit est obtenu par le respect de trois conditions.

a) la première condition vise à supprimer l'effet du bruit en charge vu par l'îlot. Contrairement à la boîte de Cooper mesurée en charge, il est possible selon l'invention de choisir le rapport entre les paramètres énergie Josephson $E_J$ et énergie de Coulomb Ec de façon à pouvoir simultanément :

- assurer l'anharmonicité du spectre des énergies pour former effectivement un qubit,
- rendre la fréquence de transition quasi-complètement insensible au bruit en charge,
- manipuler l'état du qubit par application de tensions radiofréquence sur la grille 131 de l'îlot.

b) la seconde condition vise à limiter la relaxation du qubit, qui contribue à la décohérence, lorsque ce dernier est placé dans son état excité conventionnellement noté l1 >. En effet, un qubit peut se désexciter en transférant son énergie à son environnement immédiat, en l'occurrence ici dans l'ensemble du circuit électrique. Plus précisément, ce transfert s'effectue vers la partie réelle 137 de l'impédance électrique équivalente 137, 138 telle qu'elle est vue du qubit (Figure 7). Cette impédance, même minimisée, ne peut être rigoureusement nulle. Pour que le transfert d'énergie soit nul, il faut donc imposer comme condition qu'aucun courant ne circule dans la boucle supraconductrice du qubit. Cette condition d'annulation du courant de la boucle du circuit est obtenue en annulant précisément la phase aux bornes de la combinaison série des deux jonctions Josephson de la boîte à paires de Cooper, au moyen d'une combinaison appropriée d'un courant dans la jonction Josephson de mesure et d'un flux magnétique à travers la boucle supraconductrice du qubit, ce flux étant appliqué par un aimant permanent adéquat, soit par une boucle d'induction parcourue par un courant de commande. Cette condition doit être vérifiée pendant les phases d'écriture et de maintien, quel que soit l'état du qubit et donc quel que soit le flux à annuler.

c) la troisième condition vise à limiter l'influence des paramètres d'environnement sur la décohérence. Si on note par lΨ(t=0)> l'état superposé suivant :

$$lΨ(t=0)> = l0> + l1>$$

Idéalement, cet état évolue librement par déphasage relatif des composantes l0> et l1> à la fréquence de transition $v_{01}$ du qubit :

$$lΨ(t)> = l0> + \exp(2i\pi v_{01}t)\, l1>$$

Si la fréquence de transition $\nu_{01}$ dépend de paramètres extérieurs que l'on représente par la variable générique x, tout bruit sur cette variable générique x se traduit par une fluctuation de la fréquence de transition $\nu_{01}$ et donc par une erreur aléatoire sur le déphasage relatif des composantes I0> et I1>: C'est le phénomène de décohérence. La décohérence est donc minimale quand la fréquence de transition $\nu_{01}$ est stationnaire vis-à-vis de x, c'est-à-dire quand est remplie la condition :

$$d\nu_{01} / dx = 0$$

Pour l'invention, les paramètres extérieurs dont dépend la fréquence de transition $\nu_{01}$, et qui ont été symbolisés par la variable générique x, sont essentiellement au nombre de deux : la tension continue $V_g$ appliquée au condensateur 103 et le flux magnétique $\phi$ à travers la boucle supraconductrice constituant le qubit proprement dit. Les valeurs de $V_g$ et $\phi$ sont donc ajustées de telle sorte que soient remplies simultanément les deux conditions :

$$d\nu_{01} / dV_g = 0$$

$$d\nu_{01} / d\phi = 0$$

ce qui minimise la décohérence, notamment dans le cas d'un état superposé du qubit.

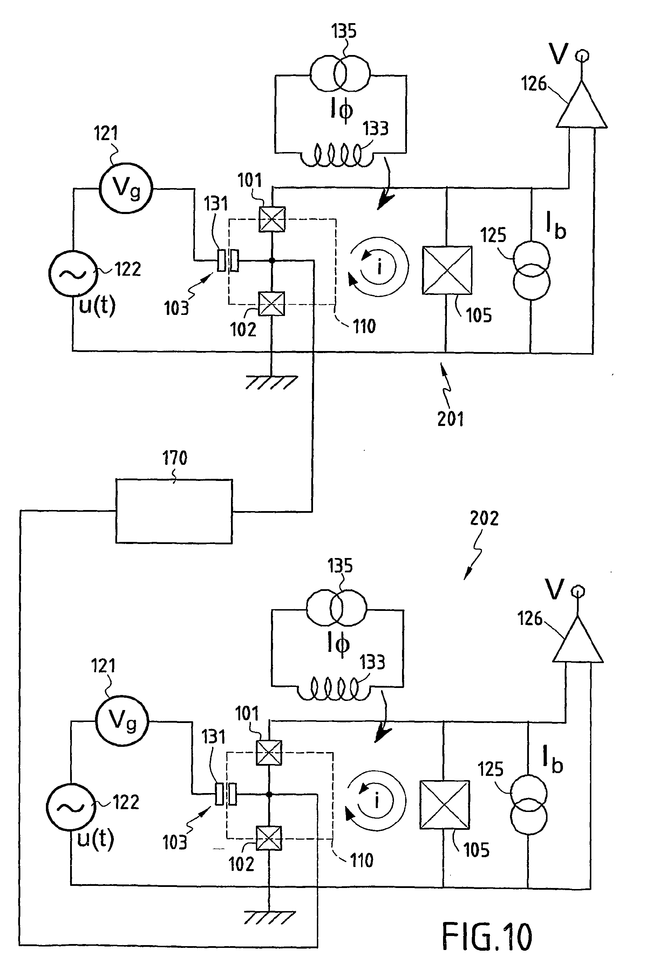

Enfin le qubit objet de l'invention peut être couplé à un ou plusieurs autres qubits possédant aussi un îlot. Ceci s'obtient par l'adjonction, entre leurs îlots respectifs, d'un dispositif de couplage électromagnétique 170 qui ne modifie pas de façon significative la valeur du rapport $E_J/E_C$ effectif de chacun des circuits 201, 202 constituant les qubits (Figure 10). De façon préférentielle, ce dispositif de couplage est un condensateur reliant les îlots de deux qubits successifs 201, 202.

Le fonctionnement d'un exemple de dispositif selon l'invention sera explicité à l'aide du schéma de principe de la Figure 4.

L'îlot de charges est délimité par les isolants des jonctions Josephson 101 et 102. Ces jonctions 101 et 102 ont des caractéristiques très proches. Leur surface a de très petites dimensions (environ 0,1 $\mu$m sur 0,1 $\mu$m) et elles sont conçues pour que le rapport $E_J/E_C$ de chacune soit compris entre 1 et 3. La valeur de ce rapport $E_J/E_C$ pour la jonction effective de la boîte à paires de Cooper 110, quatre fois plus élevée, est donc comprise entre et 4 et 12.

La boucle supraconductrice se referme par une jonction de lecture 105 de dimensions très supérieures (environ 3 $\mu$m sur 0,3 $\mu$m), se comportant quasiment comme un court-circuit pour le qubit en dehors des étapes de mesure. Ceci en raison de son énergie Josephson $E_{jl}$ environ 100 fois supérieure à l'énergie Josephson des jonctions 101 et 102. Par ailleurs, le rapport $E_J/E_C$ de cette jonction de lecture 105 est environ 5000 à 10000 fois plus élevé que le rapport $E_J/E_C$ des jonctions 101 et 102.

Cette boucle est soumise à un flux magnétique $\phi$ ajustable induit soit par un aimant permanent, soit par une bobine 133 ou un fil électrique parcourus par un courant issu d'une source de courant 135, placés à proximité, éventuellement sur le même substrat que le qubit. Ce flux $\phi$ permet de régler la coordonnée $\delta$ du point de fonctionnement pendant la manipulation du qubit. En particulier, il permet de compenser un courant de repos négatif dans la jonction de lecture 105 en maintenant la phase $\delta$ à la valeur préférentielle.

Cette combinaison de flux magnétique à travers la boucle et de courant de repos négatif dans la jonction de mesure 105 permet d'augmenter le pouvoir de discrimination des états 0 et 1 lors de la lecture : en effet, l'amplitude de l'impulsion de courant $I_b$ servant à la lecture doit alors être augmentée pour conduire à la commutation de la jonction de lecture. Cette augmentation d'amplitude se traduit par un déplacement de la phase lors de la lecture (voir figure 6) vers des valeurs où la différence des courants de boucle i1-i0 est plus grande que ce qu'elle serait dans le cas d'un flux magnétique et d'un courant de repos nuls.

On décrira maintenant en référence à la Figure 7 un mode de réalisation particulier du dispositif selon l'invention.

Le circuit est réalisable avec tout matériau supraconducteur de type S comme par exemple l'aluminium ou le niobium. Une réalisation préférentielle a été effectuée sur un substrat Si/SiO$_2$ par dépôt sous vide de films conducteurs en aluminium.

Les jonctions Josephson 101 et 102 sont réalisées par deux rubans d'aluminium déposés suivant un même axe, mais séparés de quelques centaines de nanomètres. Ces rubans sont oxydés en Al$_2$O$_3$. Puis un troisième ruban de faible longueur est déposé au niveau de la séparation entre les deux premiers rubans de telle sorte que ce ruban recouvre les deux premiers sur deux aires d'environ 0,1 $\mu$m x 0,1 $\mu$m chacune, constituant de ce fait les deux jonctions Josephson 101, 102. Ce troisième ruban constitue l'îlot de la boîte à paires de Cooper, et donc aussi la première armature 131 du condensateur 103 de capacité $C_g$. Parallèlement à ce nouveau ruban, un autre ruban est réalisé, qui constituera la seconde armature du condensateur 103.

L'îlot de charges ainsi formé est de faibles dimensions.

Le reste de la boucle du qubit proprement dit est réalisé de manière analogue, mais la surface de la jonction Josephson de lecture 105 est bien plus importante, environ 1 $\mu m^2$.

La température de fonctionnement du circuit doit être largement inférieure à l'énergie de transition du qubit divisée par la constante de Boltzmann $k_B$. Elle est en pratique de l'ordre de 50 mK, et est obtenue avec un réfrigérateur à dilution $He_3/He_4$.

La Figure 7 correspond à un mode de réalisation préféré.

La source de tension de polarisation $V_g$ de la boîte de Cooper 110 est reliée, à travers le filtre passe-bas 147 puis la résistance 132 assurant l'adaptation d'impédance à une ligne coaxiale de 50 ohms, à la grille de commande 131 de la boîte de Cooper 110.

De façon analogue, la source radio fréquence 122 est reliée à travers un atténuateur 141, un condensateur 143 et une résistance d'adaptation d'impédance à une ligne coaxiale de 50 ohms, à la grille de commande 131.

La boucle supraconductrice formée des jonctions Josephson 101, 102 et de la jonction Josephson de lecture 105 est filtrée par un condensateur 136 qui permet aussi d'éloigner significativement la fréquence de la boucle de lecture de la fréquence du qubit.

La résistance 137 et le condensateur 138 modélisent respectivement la partie réelle et la partie imaginaire de l'impédance du circuit vue du qubit.

Le flux magnétique $\phi$ est ajusté par une source de courant réglable 135 reliée à une bobine d'induction 133 assez large pour appliquer un flux uniforme à travers tout le qubit.

La source de courant de lecture 125 est en réalité réalisée à l'aide d'un source de tension V 155, d'un diviseur résistif 154 divisant par 200, d'un filtre passe-bas 152 et d'une résistance 151, de l'ordre de 3 000 ohms. Les résistances 153 et 156, toutes deux de 50 ohms, servent à la fois à permettre le fonctionnement du diviseur résistif 154 et à adapter la ligne à une impédance de 50 ohms.

Enfin, la détection du basculement de la jonction Josephson de lecture 105 s'effectue à travers la résistance 161 qui augmente l'impédance du circuit situé en aval. Ce circuit comporte un filtre passe-bas 162 puis un amplificateur 126 à haute impédance d'entrée.

La Figure 8 représente dans sa partie supérieure le chronogramme du signal d'écriture u(t) constitué par des salves d'impulsions à une fréquence égale à ou proche de $v_{01}$, dont la durée dépend de l'état quantique à inscrire puis, dans sa partie inférieure, le chronogramme des impulsions de courant de lecture $I_b$.

Enfin, la Figure 9 représente la probabilité $P_s$ de trouver le bit quantique dans l'état |1> après une séquence de deux rotations séparées par un intervalle de temps variable.

## Revendications

**1.** Dispositif de bit quantique supraconducteur à jonctions Josephson, présentant un premier degré de liberté principal affecté à l'écriture constitué par une charge, et un deuxième degré de liberté principal affecté à la lecture, constitué par une phase, ce dispositif comprenant :

- une boîte à paires de Cooper (110) comportant des première et deuxième jonctions Josephson (101, 102) délimitant un îlot de charge de la boîte (110) à paires de Cooper et se refermant sur une boucle supraconductrice pour former un qubit,
- un circuit d'écriture comprenant une électrode de grille (131) placée en regard de ladite boîte à paires de Cooper et constituant avec elle un condensateur (103) de capacité $C_g$, l'électrode de grille (131) capacitivement liée à l'îlot de charges permettant de placer ce qubit dans l'un ou l'autre des deux états de base du qubit ou dans une superposition cohérente de ces états, une tension de polarisation ($V_g$) étant appliquée à l'électrode de grille (131) à partir d'une source de tension ajustable (121),
- un circuit de lecture comprenant une jonction Josephson de lecture $J_L$ (105) insérée dans ladite boucle supraconductrice, et d'énergie Josephson sensiblement supérieure à l'énergie Josephson de chacune desdites première et deuxième jonctions Josephson (101, 102), et
- des moyens (133, 135) aptes à faire traverser la boucle supraconductrice par un flux magnétique ajustable agissant sur la phase $\delta$ du qubit,

ce dispositif étant **caractérisé en ce que** les jonctions Josephson (101, 102) définissant l'îlot de charge présentent un rapport $E_J/E_C$ entre leur énergie Josephson $E_J$ et leur énergie de Coulomb $E_C$ qui est compris entre 1 et 3, **en**

**ce que** la jonction Josephson de lecture $J_L$ (105) a une énergie Josephson au moins 50 fois supérieure à l'énergie Josephson de chacune desdites première et deuxième jonctions Josephson (101, 102) et **en ce que** la jonction Josephson de lecture (105) a un rapport $E_J/E_C$ effectif, compte tenu de la capacité ajoutée par le circuit de lecture, assez grand pour que les fluctuations de sa phase induites par le circuit extérieur soient inférieures à 0,01 rad.

2. Dispositif selon la revendication 1, **caractérisé en ce qu'**il comprend un circuit de lecture, indépendant du circuit d'écriture, galvaniquement connecté à la dite boucle supraconductrice du qubit, et comportant, outre la jonction Josephson de lecture (105), d'une part des moyens (125) pour appliquer pendant la phase de lecture une impulsion de courant $I_b$ de durée et d'amplitude paramétrables, et d'autre part des moyens de détection (161, 162, 126) des sauts de phase de $2\pi$ aux bornes de la jonction Josephson de lecture (105) qui apparaissent, suite à l'impulsion de lecture, pour l'un des deux états exclusivement.

3. Dispositif selon l'une quelconque des revendications 1 et 2, **caractérisé en ce qu'**il est préréglé, par ses paramètres $N_g$ de charge de polarisation, et $\delta$ de différence de phases supraconductrices liée au flux magnétique $\Phi_i$ traversant la boucle supraconductrice et au courant de lecture $I_b$, en un point de fonctionnement $F_i$ où la fréquence de transition $V_{01}$ du qubit est stationnaire vis-à-vis des deux paramètres de réglage Ng et $\delta$, ce point correspondant aussi à une stationnarité vis-à-vis des paramètres extérieurs.

4. Dispositif selon la revendication 3, **caractérisé en ce que** son point de fonctionnement $F_i$ est un point ($F_1$) constituant un point col du graphe tridimensionnel représentant la fréquence propre $v_{01}$ du qubit en fonction de $N_g$ et $\delta$.

5. Dispositif selon la revendication 3, **caractérisé en ce que** son point de fonctionnement $F_i$ est un point ($F_2$ ou $F_3$) constituant un point sommet du graphe tridimensionnel représentant la fréquence propre $v_{01}$ du qubit en fonction de $N_g$ et $\delta$.

6. Dispositif selon la revendication 2 et l'une quelconque des revendications 3 à 5, **caractérisé en ce que**, en dehors des séquences de lecture produisant des impulsions de lecture ayant une valeur de crête $I_{bc}$, les moyens d'application d'une impulsion de courant délivrent un courant de repos, négatif par rapport au sens des impulsions de lecture, avec une valeur absolue inférieure à la valeur de crête $I_{bc}$, permettant d'obtenir, lorsqu'une impulsion de lecture arrive, un déplacement de la différence de phase supraconductrice $\delta$ compris entre $\pi/2$ et $\pi$.

**Claims**

1. Superconducting quantum-bit device based on Josephson junction having a first principal degree of freedom assigned to writing due to a charge and a second principal degree of freedom assigned to reading due to a phase, said device comprising:

   - a Cooper-pair box (110) comprising first and second Josephson junctions (101, 102) defining a charge island of the Cooper-pair box (110) closing up onto a superconducting loop in order to form a qubit;
   - a write circuit comprising a gate electrode (131) placed facing the said Cooper-pair box island and constituting with it a capacitor (103) of capacitance Cg, the gate electrode (131) capacitively coupled to the charge island, allowing this qubit to be placed in one or other of the two base states of the qubit or in a coherent superposition of these states, a bias voltage Vg being applied to the gate electrode (131) from an adjustable voltage source (121); and
   - a read circuit comprising a read Josephson junction $J_L$ (105) inserted into the said superconducting loop and having a Josephson energy substantially greater than the Josephson energy of each of the first and second Josephson junctions (101, 102), and
   - means (133, 135) capable of inducing an adjustable magnetic flux pass through the superconducting loop, by acting on the phase $\delta$ of the qubit,
   said device being **characterized in that** the Josephson junctions (101, 102) defining the charge island have a ratio, $E_J/E_C$, of their Josephson energy $E_J$ to their Coulomb energy $E_C$ which is between 1 and 3, **in that** the read Josephson junction $J_L$ (105) has a Josephson energy at least 50 times greater than the Josephson energy of each of the first and second Josephson junctions (101, 102) and **in that** the read Josephson junction (105) has an effective $E_J/E_C$ ratio, taking into account the capacitance added by the read circuit, high enough for the fluctuations in its phase which are induced by the external circuit to be less than 0.01 rd.

2. Device according to Claim 1, **characterized in that** it includes a read circuit, independently of the write circuit, galvanically connected to the said superconducting loop of the qubit and having, apart from the read Josephson junction (105), on the one hand, means (125) for applying, during the read phase, a current pulse $I_b$ of parameterizable duration and amplitude and, on the other hand, means (161, 162, 126) for detecting the $2\pi$ phase jumps at the terminals of the read Josephson junction (105) which appear, as a result of the read pulse, exclusively for one of the two states.

3. Device according to anyone of Claims 1 and 2, **characterized in that** it is preset by its parameters namely the bias charge Ng and the superconducting phase difference $\delta$ due to the magnetic flux $\Phi j$ flowing through the superconducting loop and to the read current $I_b$, at an operating point $F_i$ where the transition frequency $V_{01}$ of the qubit is stationary with respect to the two setting parameters Ng and $\delta$, this point also corresponding to a stationary character with respect to external parameters.

4. Device according to Claim 3, **characterized in that** its operating point $F_i$ of the device is the point ($F_1$) constituting a saddle point on the three-dimensional graph representing the eigenfrequency $V_{01}$ of the qubit as a function of Ng and $\delta$.

5. Device according to Claim 3, **characterized in that** its operating point $F_i$ is a point ($F_2$ or $F_3$) constituting a peak point on the three-dimensional graph representing the eigenfrequency $v_{01}$ of the qubit as a function of Ng and $\delta$.

6. Device according to Claim 2 and anyone of claims 3 to 5, **characterized in that** out of the reading sequences producing read pulses having a peak value $I_{bc}$, the means for applying a current pulse deliver a quiescent current which is negative with respect to the direction of the read pulses with an absolute value which is less than the peak value $I_{bc}$, making it possible, when a read pulse arrives, to displace the superconducting phase difference $\delta$ by between $\pi/2$ and $\pi$.

**Patentansprüche**

1. Supraleitende Quantenbitvorrichtung mit Josephson-Übergängen, die einen dem Schreiben zugewiesenen, von einer Ladung gebildeten ersten Hauptfreiheitsgrad sowie einen dem Lesen zugewiesenen, von einer Phase gebildeten zweiten Hauptfreiheitsgrad aufweist, wobei diese Vorrichtung folgendes umfaßt:

- eine Cooper-Paar-Box (110) mit einem ersten und einem zweiten Josephson-Übergang (101, 102), die eine Ladungsinsel der Cooper-Paar-Box (110) begrenzen und sich an einer supraleitenden Schleife schließen, um ein Qubit zu bilden,
- einen Schreibkreis, der eine Gate-Elektrode (131) aufweist, die gegenüber der Cooper-Paar-Box angeordnet ist und mit dieser einen Kondensator (103) der Kapazität $C_g$ bildet, wobei die Gate-Elektrode (131), die mit der Ladungsinsel kapazitiv verbunden ist, ermöglicht, dieses Qubit in den einen oder den anderen der beiden Grundzustände des Qubits oder in eine kohärente Superposition dieser Zustände zu bringen, wobei von einer einstellbaren Spannungsquelle (121) aus eine Polarisationsspannung (Vg) an die Gate-Elektrode (131) angelegt wird,
- einen Lesekreis, der einen Lese-Josephson-Übergang $J_L$ (105) aufweist, der in die supraleitende Schleife eingefügt ist und eine Josephson-Energie hat, die wesentlich größer als die Josephson-Energie eines jeden des ersten und des zweiten Josephson-Übergangs (101, 102) ist, sowie
- Mittel (133, 135), die geeignet sind, die supraleitende Schleife von einem einstellbaren, auf die Phase $\delta$ des Qubits wirkenden Magnetfluß durchfließen zu lassen,
wobei diese Vorrichtung **dadurch gekennzeichnet ist, daß** die Josephson-Übergänge (101, 102), welche die Ladungsinsel definieren, ein $E_J/E_C$-Verhältnis zwischen ihrer Josephson-Energie Ej und ihrer Coulomb-Energie $E_C$ aufweisen, das zwischen 1 und 3 liegt, daß der Lese-Josephson-Übergang $J_L$ (105) eine Josephson-Energie hat, die wenigstens 50 mal größer ist als die Josephson-Energie eines jeden des ersten und des zweiten Josephson-Übergangs (101, 102), und daß der Lese-Josephson-Übergang (105) aufgrund der durch den Lesekreis hinzugefügten Kapazität ein tatsächliches $E_J/E_C$-Verhältnis hat, das groß genug ist, damit die durch den Außenkreis induzierten Schwankungen seiner Phase kleiner als 0,01 rad sind.

2. Vorrichtung nach Anspruch 1, **dadurch gekennzeichnet, daß** sie einen von dem Schreibkreis unabhängigen Lesekreis umfaßt, der mit der supraleitenden Schleife des Qubits galvanisch verbunden ist und der außer dem Lese-Josephson-Übergang (105) einerseits Mittel (125) aufweist, um während der Lesephase einen Stromimpuls $I_b$ mit parametrierbarer Dauer und Amplitude anzulegen, und andererseits Mittel (161, 162, 126) zum Erfassen der Pha-

sensprünge von $2\pi$ an den Anschlüssen des Lese-Josephson-Übergangs (105), die infolge des Leseimpulses ausschließlich für den einen der beiden Zustände auftreten.

3. Vorrichtung nach einem der Ansprüche 1 und 2, **dadurch gekennzeichnet, daß** sie durch ihre Parameter Ng der Polarisationsladung und $\delta$ der supraleitenden Phasenverschiebung, die mit dem die supraleitende Schleife durchströmenden Magnetfluß $\phi_l$ und mit dem Lesestrom $I_b$ verbunden ist, in einem Arbeitspunkt $F_i$ voreingestellt wird, in dem die Übergangsfrequenz $\nu_{01}$ des Qubits gegenüber den beiden Einstellparametern Ng und $\delta$ stationär ist, wobei dieser Punkt auch einer Stationarität gegenüber äußeren Parametern entspricht.

4. Vorrichtung nach Anspruch 3, **dadurch gekennzeichnet, daß** ihr Arbeitspunkt $F_i$ ein Punkt ($F_1$) ist, der einen Sattelpunkt des dreidimensionalen Graphen bildet, welcher die Eigenfrequenz $\nu_{01}$ des Qubits in Abhängigkeit von Ng und $\delta$ darstellt.

5. Vorrichtung nach Anspruch 3, **dadurch gekennzeichnet, daß** ihr Arbeitspunkt $F_i$ ein Punkt ($F_2$ oder $F_3$) ist, der einen Scheitelpunkt des dreidimensionalen Graphen bildet, welcher die Eigenfrequenz $\nu_{01}$ des Qubits in Abhängigkeit von Ng und $\delta$ darstellt.

6. Vorrichtung nach Anspruch 2 und nach einem der Ansprüche 3 bis 5, **dadurch gekennzeichnet, daß** außerhalb der Lesesequenzen, die Leseimpulse mit einem Spitzenwert $I_{bc}$ erzeugen, die Mittel zum Anlegen eines Stromimpulses einen bezogen auf die Richtung der Leseimpulse negativen Ruhestrom mit einem Absolutwert, der kleiner als der Spitzenwert $I_{bc}$ ist, liefern, was ermöglicht, bei Eintreffen eines Leseimpulses eine Verlagerung der supraleitenden Phasenverschiebung $\delta$ zwischen $\pi/2$ und $\pi$ zu erreichen.

EP 1 506 581 B1

FIG.1

ART ANTERIEUR

FIG.2

ART ANTERIEUR

$I_{bias}$

54

53

51

52

55

# FIG.3
## ART ANTERIEUR

135

$I_\phi$

133

V

126

121

$V_g$

131

101

122

$u(t)$

103

102

110

$i_0$

$i_1$

105

125

$I_b$

# FIG.4

FIG.5

FIG.6

FIG.7

FIG.8

FIG.9

FIG.10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0150534 A
- WO 0215290 A

**Littérature non-brevet citée dans la description**

- **V. BOUCHIAT ; D. VION ; P. JOYEZ ; D. ESTEVE ; M. H. DEVORET.** Quantum coherence with a single Cooper pair. *Physica Scripta,* 1998, vol. T76, 165
- **NAKAMURA et al.** *NATURE,* 29 Avril 1999, vol. 398
- **J.E.MOOIJ ; C.VAN DER WAL et al.** l'UT-DELFT ''Josephson persistent-current qubit. *SCIENCE,* 13 Août 1999, vol. 285, 1037-1039
- **C.VAN DER WAL ; J.E. MOOIJ et al.** l'UT-DELFT ''Quantum superposition of macroscopic persistent-current states. *SCIENCE,* 27 Octobre 2000, vol. 290, 773-776
- **A. COTTET et al.** Implementation of a combined charge-phase quantum bit in a superconducting circuit. *Physica C,* 15 Février 2002, vol. 367 (1-4), 197-203